(19) Europäisches Patentamt
European Patent Office
Office européen des brevets

(11) **EP 3 915 827 B1**

(12) **EUROPEAN PATENT SPECIFICATION**

(45) Date of publication and mention
of the grant of the patent:
**16.08.2023 Bulletin 2023/33**

(21) Application number: **20919375.4**

(22) Date of filing: **16.10.2020**

(51) International Patent Classification (IPC):
*B60L 53/60* (2019.01)   *H02J 7/00* (2006.01)
*G01R 31/36* (2020.01)   *H01M 10/42* (2006.01)
*H01M 10/44* (2006.01)   *B60L 53/62* (2019.01)
*B60L 58/12* (2019.01)

(52) Cooperative Patent Classification (CPC):
**B60L 53/62; B60L 58/12; H01M 10/425;**
**H01M 10/44; H02J 7/0047;** B60L 2260/54;
B60L 2260/58; G01R 31/382; H02J 2310/48;
Y02E 60/10; Y02T 10/70; Y02T 10/7072;
Y02T 90/12

(86) International application number:
**PCT/CN2020/121498**

(87) International publication number:
**WO 2021/208387 (21.10.2021 Gazette 2021/42)**

(54) **CHARGING REMAINING TIME CALCULATION METHOD AND APPARATUS, AND STORAGE MEDIUM**

VERFAHREN UND VORRICHTUNG ZUR BERECHNUNG DER RESTLADEZEIT UND
SPEICHERMEDIUM

PROCÉDÉ ET APPAREIL DE CALCUL DE TEMPS RESTANT DE CHARGE, ET SUPPORT DE
STOCKAGE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **17.04.2020   CN 202010306502**

(43) Date of publication of application:
**01.12.2021 Bulletin 2021/48**

(73) Proprietor: **Guangdong Xiaopeng Motors**
**Technology Co., Ltd.**
**Sino-Singapore Knowledge City, Huangpu**
**District**
**Guangzhou, Guangdong 510555 (CN)**

(72) Inventor: **CHEN, Qiwu**
**Guangzhou, Guangdong 510555 (CN)**

(74) Representative: **Ran, Handong**
**Maucher Jenkins**
**Seventh Floor Offices**
**Artillery House**
**11-19 Artillery Row**
**London SW1P 1RT (GB)**

(56) References cited:
WO-A1-2015/007145      CN-A- 101 436 690
CN-A- 106 787 011      CN-A- 108 646 190
CN-A- 110 562 097      CN-A- 110 562 097
CN-A- 111 422 092      JP-A- 2006 262 605
KR-A- 20190 023 801    US-A1- 2012 098 500
US-A1- 2018 170 208    US-B1- 6 281 663
US-B2- 6 928 372

## Description

### TECHNICAL FIELD

The present disclosure relates to the field of power batteries, and more particularly, to a method and an apparatus for calculating remaining time of charging, and a storage medium.

### BACKGROUND

In the face of environmental pollution, traffic congestion and energy shortages caused by the automotive industry, new energy vehicles will inevitably replace the market share of conventional fuel vehicles to a certain extent. In the future, there is huge room for the development of new energy vehicles. The new energy vehicles may gradually become the main force in the development of the automotive industry. The human industrialization process has gone through the age of steam, the age of internal combustion engines, and the age of electricity. We're now still in the latter half of the age of electricity, and the ultimate goal is the full electrification of the society. Replacing fossil fuels with electricity as a power source is a gradual process and an inevitable trend.

Charging is an indispensable function of electric vehicles. The current charging modes are classified into alternating current charging and direct current charging.

A charging pile of an alternating current electric vehicle, commonly known as "slow charger", is a power supply device that is fixedly mounted outside the electric vehicle and connected to an alternating current power grid to provide an alternating current power source for an on-board charger of the electric vehicle (i.e., a charger that is fixedly mounted on the electric vehicle). A charging station of a direct current electric vehicle, commonly known as "fast charger", is a power supply device that is fixedly mounted outside the electric vehicle and connected to the alternating current power grid to provide a direct current power source for a power battery of the electric vehicle.

When it comes to charging, remaining time of charging is an indicator of great concern, for a reason that this indicator can clearly tell waiting time to a vehicle owner. Therefore, the vehicle owner can plan events that can be done according to a duration of the remaining time of the charging, and even the accuracy of the remaining time of the charging can let the vehicle owner feel the sense of technology of the vehicle subjectively. Normally, alternating current charging requires very long charging time, so a large error in an estimation of the charging time will not affect experience in general. However, since the time it takes for direct current charging is short (usually 1.5 hours for full charge), a large error will cause complaints from the vehicle owner and affect the experience of the vehicle owner. CN110562097A discloses a new energy automobile charging residual time estimation method. The method includes the following steps of 1: dividing the charging process from 0% to 100% of battery charging into n charging stages according to the sequence before and after charging through an electric quantity percentage node, the electric quantity percentage node including SOC1, SOC2, SOC3... SOCn with the electric quantity percentage value increasing in sequence; 2: calculating the charging time corresponding to each charging stage in the n stages respectively; 3: acquiring the SOC of the current battery, comparing the SOC with each power percentage node respectively, and judging the charging stage at this time; 4: calculating the time T from the charging of the percentage of electricity SOC to the end of the charging phase and obtain the time of each subsequent charging phase of the current charging phase; and 5: adding the time T and the time of each subsequent charging stage in the current charging stage to obtain the estimated remaining charging time. KR20190023801 discloses a vehicle and a control method thereof. The vehicle minimizes an error with actual charging time by calculating expected charging time for each vehicle after reflecting a learning value of electric field load consumption during charging which can occur for each vehicle, and provides the calculated expected charging time to a user so that the user can recognize an end point and utilize the time effectively. US 6,928,372 B2 discloses a method for determining time to completion is provided for a battery charging system, which can tell a user how much time is remaining until a rechargeable battery is fully charged.

### SUMMARY

An embodiment of the present disclosure discloses a method and an apparatus for calculating remaining time of charging, and a storage medium, which can improve an accuracy of the remaining time of the charging.

In a first aspect, an embodiment of the present disclosure discloses a method for calculating remaining time of charging. The charging includes at least one charging stage. The method for calculating the remaining time of the charging includes: obtaining a charging mode and adjusting at least one of $Rd_c$, $I_{avg}$, $Rd_{In}$, or $I_{In}$ based on the charging mode, where $Rd_c$ represents a number of charging ampere hours required to charge a battery in a current charging stage, $I_{avg}$ represents an average current requested to charge the battery in the current charging stage, Rdin represents a number of charging ampere hours required to charge the battery in a subsequent n-th charging stage, and $I_{In}$ represents

a requested current requested to charge the battery in the subsequent n-th charging stage; and calculating the remaining time of the charging by $T = \dfrac{Rd_c}{I_{avg}} + \sum \dfrac{Rd_{1n}}{I_{1n}}$, where T represents the remaining time of the charging, $\dfrac{Rd_c}{I_{avg}}$ represents charging time of the current charging stage, $\dfrac{Rd_{1n}}{I_{1n}}$ represents charging time of the subsequent n-th charging stage, and $\sum \dfrac{Rd_{1n}}{I_{1n}}$ represents charging time of all subsequent charging stages. The obtaining the charging mode and the adjusting the at least one of $Rd_c$, $I_{avg}$, $Rd_{1n}$, or $I_{1n}$ based on the charging mode includes obtaining a dynamic change mode as the charging mode, and adjusting Iin to $I_{1n2}$ based on the dynamic change mode. $I_{1n2}$ is obtained by $I_{1n2}= min(I_{1n}, I_{avgpret})$, where $I_{avgpret}$ represents an average current value of a charging pile, and $min(I_{1n}, I_{avgpret})$ represents a smaller one of $I_{1n}$ and $I_{avgpret}$. $I_{avgpret}$ is obtained by obtaining the average current value of the charging pile in a time period of T1 as $I_{avgpret}$ in response to a duration of $I_p -M_1>I_1$ exceeding T1 during the charging, where $I_p$ represents a charging current requested by a battery management system (BMS), $M_1$ represents a current of the charging pile, $I_1$ represents a first predetermined current threshold, and T1 represents a first predetermined time threshold. The dynamic change mode is a state in which the duration of $I_p-M_1>I_1$ exceeds T1 during the charging.

In a second aspect, an embodiment of the present disclosure discloses an apparatus for calculating remaining time of charging of a battery including: a charging mode obtaining module configured to obtain a charging mode; a parameter adjustment module configured to adjust at least one of $Rd_c$, $I_{avg}$, $Rd_{1n}$, or $I_{1n}$ based on the obtained charging mode, where $Rd_c$ represents a number of charging ampere hours required to charge a battery in a current charging stage, $I_{avg}$ represents an average current requested to charge the battery in the current charging stage, $Rd_{1n}$ represents a number of charging ampere hours required to charge the battery in a subsequent n-th charging stage, and $I_{1n}$ represents a requested current requested to charge the battery in the subsequent n-th charging stage; and a charging remaining time calculation module configured to calculate the remaining time of the charging by $T = \dfrac{Rd_c}{I_{avg}} + \sum \dfrac{Rd_{1n}}{I_{1n}}$, where T represents the remaining time of the charging, $\dfrac{Rd_c}{I_{avg}}$ represents charging time of the current charging stage, $\dfrac{Rd_{1n}}{I_{1n}}$ represents charging time of the subsequent n-th charging stage, and $\sum \dfrac{Rd_{1n}}{I_{1n}}$ represents charging time of all subsequent charging stages. The charging mode obtaining module is further configured to obtain a dynamic change mode as the charging mode. The parameter adjustment module is further configured to adjust $I_{1n}$ to $I_{1n2}$ based on the dynamic change mode. $I_{1n2}$ is obtained by $I_{1n2}= min(I_{1n}, I_{avgpret})$, where $I_{avgpret}$ represents an average current value of a charging pile, and $min(I_{1n}, I_{avgpret})$ represents a smaller one of $I_{1n}$ and $I_{avgpret}$. $I_{avgpret}$ is obtained by obtaining the average current value of the charging pile in a time period of T1 as $I_{avgpret}$ in response to a duration of $I_p-M_1>I_1$ exceeding T1 during the charging, where $I_p$ represents a charging current requested by a battery management system (BMS), $M_1$ represents a current of the charging pile, $I_1$ represents a first predetermined current threshold, and T1 represents a first predetermined time threshold. The dynamic change mode is a state in which the duration of $I_p-M_1>I_1$ exceeds T1 during the charging.

In a third aspect, an embodiment of the present disclosure discloses a computer-readable storage medium having a computer program stored thereon. The computer program causes an apparatus according to the appended claims to perform the method for calculating the remaining time of the charging according to an embodiment in the first aspect of the present disclosure.

Compared with the related art, an embodiment of the present disclosure has the following beneficial effects. In the embodiments of the present disclosure, the remaining time of the charging is calculated by performing recognition with respect to a plurality of charging modes, and adjusting parameters in accordance with different modes, such that a calculation result of the remaining time of the charging is more accurate.

## BRIEF DESCRIPTION OF DRAWINGS

In order to clearly explain technical solutions of embodiments of the present disclosure, drawings used in the embodiments are briefly described below. Apparently, the drawings as described below are merely some embodiments of the present disclosure. Based on these drawings, other drawings can be obtained by those skilled in the art without creative effort.

FIG. 1 is a flowchart illustrating a method for calculating remaining time of charging according to an embodiment of the present disclosure; and

FIG. 2 is a block diagram showing an apparatus for calculating remaining time of charging according to an embodiment of the present disclosure.

## DESCRIPTION OF EMBODIMENTS

The technical solutions in the embodiments of the present disclosure will be clearly and completely described below with reference to the accompanying drawings in the embodiments of the present disclosure. Apparently, the embodiments described here are only part of the embodiments of the present disclosure and are not all embodiments of the present disclosure. Based on the embodiments of the present disclosure, other embodiments obtained by those skilled in the art without creative labor are within the scope of the present disclosure.

It should be noted that terms "first", "second", "third" and "fourth" in the description and claims of the present disclosure are used to distinguish different objects, rather than to describe a specific sequence. Terms "including" and "having" and any variation of the terms "including" and "having" in the embodiments of the present disclosure are intended to cover non-exclusive inclusions. For example, a process, a method, a system, a product, or a device that includes a series of steps or units is not necessarily limited to those clearly listed steps or units, but may include other steps or units that are not clearly listed or are inherent to the process, the method, the product, or the device.

In an embodiment of the present disclosure, in order to take into account both charging efficiency and charging safety during direct current charging, charging is divided into a plurality of charging stages. Furthermore, different charging currents are usually used at different stages according to a battery level, so time of the charging is a sum of charging time of these different stages. The charging time required to charge a battery from a battery level of 0 to a battery level of 100% can be expressed as:

$$T_{\text{fully charged}} = \sum \left( \frac{\text{a number of charging ampere hours required by a stage}}{\text{a requested current requested by charging in the stage}} \right) = \sum \frac{Rd_n}{I_n},$$

$$= \frac{\Delta SOC_{\text{stage } 1} \times Rd_{Ah}}{I_1} + \frac{\Delta SOC_{\text{stage } 2} \times Rd_{Ah}}{I_2} \ldots + \frac{\Delta SOC_{\text{stage } n} \times Rd_{Ah}}{I_n}$$

where $T_{\text{fully charged}}$ represents charging time required to charge the battery from the battery level of 0 to the battery level of 100%, $Rd_n$ represents a number of charging ampere hours required to charge the battery in an n-th charging stage,

$I_n$ represents a requested current requested to charge the battery in the n-th charging stage, $\frac{Rd_n}{I_n}$ represents charging time of the n-th charging stage, $\sum \frac{Rd_n}{I_n}$ represents charging time of all charging stages, $Rd_{Ah}$ represents a rated capacity of the battery, and $\Delta SOC_{\text{stage } n}$ represents a state of charge (SOC) of the n-th charging stage, which is usually obtained by subtracting a lower limit SOC of the n-th charging stage from an upper limit SOC of the n-th charging stage.

The following is an example of a charging current table of a battery, in which the first row displays charging stages and is represented by the range of the SOC, and the first column displays temperature ranges (unit: degrees Celsius) of the battery. An intersection of each row and each column except the first row and the first column represents a requested charging current (unit: ampere) of the charging stage in the temperature range of the battery.

Charging current table of the battery

|  | 0-50% | 50%-60% | 60%-70% | 70%-80% | 80%-90% | 90%-100% |
|---|---|---|---|---|---|---|
| -20≤Temp<-10 | 20 | 20 | 20 | 20 | 20 | 10 |
| -10≤Temp<0 | 40 | 40 | 40 | 40 | 40 | 10 |
| 0≤Temp<5 | 60 | 60 | 60 | 60 | 60 | 10 |
| 10≤Temp<20 | 80 | 80 | 80 | 80 | 80 | 10 |
| 20≤Temp<45 | 150 | 130 | 120 | 110 | 100 | 20 |
| 45≤Temp<55 | 80 | 80 | 80 | 80 | 80 | 20 |
| 55≤Temp<60 | 20 | 20 | 20 | 20 | 20 | 20 |

A time unit of $T_{fully\ charged}$ calculated based on the above method is hour, and the time unit can also be converted into minute or second according to needs of subsequent processing or display. In an embodiment of the present disclosure, unless otherwise specified, the time unit obtained by calculation is usually hour.

In actual charging, usually a current number of ampere hours is not 0, and a target battery level may not be 100%, so a method for calculating actual charging time can be expressed as:

$$T_{normal\ charging} = T_{current} + T_{subsequent}$$

$$T_{current} = \frac{Rd_c}{I_{avg}} = \frac{(SOC_{currentEnd} - SOC_{current}) \times Rd_{Ah}}{I_{avg}},$$

$$T_{subsequent} = \sum \frac{Rd_{ln}}{I_{ln}} = \frac{\Delta SOC_{subsequent\ 1} \times Rd_{Ah}}{I_{l1}} + \frac{\Delta SOC_{subsequent\ 2} \times Rd_{Ah}}{I_{l2}} ... + \frac{\Delta SOC_{subsequent\ n} \times Rd_{Ah}}{I_{ln}}$$

where $Rd_c$ represents a number of charging ampere hours required to charge the battery in a current charging stage, $I_{avg}$ represents an average current requested to charge the battery in the current charging stage, $\frac{Rd_c}{I_{avg}}$ represents charging time of the current charging stage, $Rd_{ln}$ represents a number of charging ampere hours required to charge the battery in a subsequent n-th charging stage, $I_{ln}$ represents a requested current requested to charge the battery in the subsequent n-th charging stage, $\frac{Rd_{ln}}{I_{ln}}$ represents charging time of the subsequent n-th charging stage, $\sum \frac{Rd_{ln}}{I_{ln}}$ represents charging time of all subsequent charging stages, $Rd_{Ah}$ represents the rated capacity of the battery, and $\Delta SOC_{subsequent\ n}$ represents a SOC of the subsequent n-th charging stage, which is usually obtained by subtracting a lower limit SOC of the n-th charging stage from an upper limit SOC of the n-th charging stage.

The above is the calculation method of the charging time in an ideal state. However, in reality, many different situations during charging will affect the charging time. In an embodiment of the present disclosure, a charging mode is obtained first, and then at least one of $Rd_c$, $I_{avg}$, $Rd_{ln}$, or $I_{ln}$ is adjusted based on the charging mode. Illustration is made as follows.

Case 1: an estimation of remaining time of direct current charging in an underpower mode of a charging pile

In this mode, an output power of the charging pile cannot meet a charging current requested by a battery management system (BMS). Specifically, for example, $I_{avg}$ or $I_{ln}$ is greater than $I_{max}$ in at least one stage of the charging. $I_{max}$ represents a maximum output current of the charging pile. When actually calculating the remaining time of the charging, a requested current of charging in a certain stage should be compared with the maximum output current that the charging pile can provide. If the requested current exceeds the current that the charging pile can provide, the current that the charging pile can provide is determined as an actual charging current.

Parameter adjustments in this case include: adjusting $I_{avg}$ to $I_{avg1}$, wherein $I_{avg1}$ is specifically expressed as: $I_{avg1}=\min(I_{avg}, I_{max})$; and adjusting $I_{ln}$ to $I_{ln1}$, wherein $I_{ln1}$ is specifically expressed as: $I_{ln1}=\min(I_{ln}, I_{max})$, wherein $I_{max}$ represents the maximum output current of the charging pile, $\min(I_{avg}, I_{max})$ represents a smaller one of $I_{avg}$ and $I_{max}$, and $\min(I_{ln}, I_{max})$ represents a smaller one of $I_{ln}$ and $I_{max}$. The remaining time of the charging can be specifically expressed as:

$$T_{underpower} = T_{current} + T_{subsequent}$$

$$T_{current} = \frac{Rd_c}{\min(I_{avg}, I_{max})}$$

$$T_{subsequent} = \sum \frac{Rd_{ln}}{\min(I_{ln}, I_{max})}$$

Case 2: an estimation of the remaining time of the direct current charging under a charging pile output power dynamic change mode

In this mode, the output power of the charging pile is in a state of change and a duration of the output power is uncertain. In an embodiment of the present disclosure, in order to calculate the remaining time of the charging more accurately, an average current of the charging pile is obtained first, and then the remaining time of the charging is calculated based on the average current of the charging pile. Specifically, the average current of the charging pile can be obtained in the following manner.

An average current value of the charging pile in a time period of T1 is obtained as the average current $I_{avgpret}$ of the charging pile in response to a duration of $I_p - M_1 > I_1$ exceeding T1 during the charging, where $I_p$ represents a charging current requested by the BMS, $M_1$ represents a current of the charging pile, $I_1$ represents a first predetermined current threshold, and T1 represents a first predetermined time threshold.

The dynamic change mode is specifically a state in which the duration of $I_p - M_1 > I_1$ exceeds T1 during the charging.

Parameter adjustments in this mode include adjusting $I_{ln}$ to $I_{ln2}$. $I_{ln2}$ is specifically obtained by: $I_{ln2} = \min(I_{ln}, I_{avgpret})$, where $I_{avgpret}$ represents the average current value of the charging pile.

The remaining time of the charging in this mode can be specifically expressed as:

$$T_{power\ change} = T_{current} + T_{subsequent}$$

$$T_{current} = \frac{Rd_c}{I_{avg}}$$

$$T_{subsequent} = \sum \frac{Rd_{ln}}{\min(I_{ln}, I_{avgpret})}$$

Case 3: an estimation of the remaining time of the direct current charging in a failure mode

In an embodiment of the present disclosure, charging is usually possible in the failure mode, but a charging current will be limited. Specifically, the failure mode includes but is not limited to at least one of the following situations:

1. A voltage of a battery cell being too low (for example, a lowest threshold for normal use is 2.5, and an actual voltage is smaller than 2.5V);
2. A voltage difference of a battery cell being too large (for example, the voltage difference exceeds 300mv);
3. A failure that a battery temperature is too high (for example, the temperature exceeds 50°C);

4. A temperature difference of the battery being too large (for example, the temperature difference exceeds 10°C);

5. A level-1 over-temperature failure of a fast charge connector in a Battery Disconnect Unit (BDU) (for example, over 130°C);

6. A level-1 over-temperature failure of a Manual Service Disconnect (MSD) (for example, over 120°C);

7. An over-temperature failure of a charging port socket (for example, over 85°C);

8. A failure that a zero drift of a current sensor is too large;

9. A minor failure of temperature line disconnection (for example, one sampling line is broken);

10. A minor failure of cell voltage line disconnection (for example, one sampling line is broken); and

11. A level-1 failure of too poor insulation.

In this mode, the output power of the charging pile may meet the charging current requested by the BMS. Due to a BMS failure, the charging current will be limited by a certain percentage. Parameter adjustments in this case include: adjusting $I_{avg}$ to $I_{avg3}$, wherein $I_{avg3}$ is specifically expressed as: $I_{avg3}=\min(I_{avg}, I_{max})$; and adjusting $I_{ln}$ to $I_{ln3}$, wherein $I_{ln3}$ is specifically expressed as: $I_{ln3}=\min(I_{ln}, I_{max})*AddCf$, wherein $I_{max}$ represents the maximum output current of the charging pile, $\min(I_{avg}, I_{max})$ represents a smaller one of $I_{avg}$ and $I_{max}$, and $\min(I_{ln}, I_{max})$ represents a smaller one of $I_{ln}$ and $I_{max}$, and AddCf represents a failure adjustment coefficient.

The remaining time of the charging in this case can be specifically expressed as:

$$T_{failure} = T_{current} + T_{subsequent}$$

$$T_{current} = \frac{Rd_c}{\min(I_{avg}, I_{max})}$$

$$T_{subsequent} = \sum \frac{Rd_{ln}}{\min(I_{ln}, I_{max})*AddCf}$$

Case 4: an estimation of the remaining time of the direct current charging in a mode with a high-power load

Normally, the high-power load may include, for example, an air conditioner. A case of enabling the high-power load during the charging may be that, for example, a temperature difference between an in-vehicle temperature and a temperature desired by the user is too large, and thus the air conditioner needs to be operated with a high power.

When the high-power load is enabled, direct changes include that the number of ampere hours obtained by the vehicle from the charging pile is increased, and the increased part is a part to be consumed by the high-power load. In addition, in each charging stage with the high-power load enabled, the charging current requested by the BMS will also increase, and the increased part is a working current of the high-power load.

According to the above description, parameter adjustments in this mode include: adjusting $Rd_c$ to $Rd_{cs}$, wherein $Rd_{cs}$ is specifically expressed as: $Rd_{cs}=Rd_c+HVLoadAh$, where HVLoadAh represents a number of ampere hours required by the high-power load during the charging, and in addition, in this case, it is assumed that the high-power load needs to be enabled at the current stage when the charging starts; adjusting $Rd_{ln}$ at a subsequent stage having the high-power load enabled to $Rd_{lns}$, where $Rd_{lns}$ is specifically expressed as: $Rd_{lns}=Rd_{ln}+HVLoadAh$; and adjusting $I_{ln}$ at the subsequent stage having the high-power load enabled to $I_{lns}$, where $I_{lns}$ is specifically expressed as: $I_{lns}=I_{ln}+I_{load}$, where $I_{load}$ represents a working current of the high-power load.

Specifically, the remaining time of the charging in this mode can be expressed as:

$$T_{load\ enabled} = T_{current} + T_{subsequent}$$

$$T_{current} = \frac{Rd_c+HVLoadAh}{I_{avg}} \quad ,$$

$$T_{subsequent} = \sum \frac{Rd_{ln} + HVLoadAh}{I_{ln} + I_{load}} + \sum \frac{Rd_{lm}}{I_{lm}}$$

where $\sum \dfrac{Rd_{ln} + HVLoadAh}{I_{ln} + I_{load}}$ represents a sum of charging time of respective subsequent stages having the high-power load enabled, and $\sum \dfrac{Rd_{lm}}{I_{lm}}$ represents a sum of charging time of respective subsequent stages not having the high-power load enabled.

If the maximum output current $I_{max}$ of the charging pile can meet the requested current of the charging in each charging stage, then in reality, enabling the high-power load will not exert a significant impact on the remaining time of the charging. However, during actual charging, there are often other special charging states when the high-power load is enabled, and illustration will be made below.

Sub-case A: an underpower mode with the high-power load

Parameter adjustments in this case include: adjusting $Rd_c$ to $Rd_{c4}$, wherein $Rd_{c4}$ is specifically expressed as: $Rd_{c4}=Rd_c+HVLoadAh$, where HVLoadAh represents the number of ampere hours required by the high-power load during the charging; adjusting $Rd_{ln}$ at the stage having the high-power load enabled to $Rd_{ln4}$, wherein $Rd_{ln4}$ is specifically expressed as: $Rd_{ln4}=Rd_{ln}+HVLoadAh$; adjusting $I_{avg}$ to $I_{avg4}$, wherein $I_{avg4}$ is specifically expressed as: $I_{avg4}=min((I_{avg}+I_{load1}), I_{max})$; and adjusting $I_{ln}$ at the stage having the high-power load enabled to $I_{ln4}$, wherein $I_{ln4}$ is specifically expressed as: $I_{ln4}= min((I_{ln}+I_{load1}), I_{max})$, wherein $I_{max}$ represents the maximum output current of the charging pile, $I_{load1}$ represents the working current of the high-power load, $min((I_{avg}+I_{load1}), I_{max})$ represents a smaller one of $(I_{avg}+I_{load1})$ and $I_{max}$, and $min((I_{ln}+I_{load1}), I_{max})$ represents a smaller one of $(I_{ln}+I_{load1})$ and $I_{max}$.

The underpower mode with the high-power load is specifically that: the vehicle enables the high-power load, and in at least one stage of the charging, $(I_{avg}+I_{load1})$ or $(I_{ln}+I_{load1})$ is greater than $I_{max}$.

The remaining time of the charging in this case can be specifically expressed as:

$$T_{underpower\ with\ load\ enabled} = T_{current} + T_{subsequent}$$

$$T_{current} = \frac{Rd_c + HVLoadAh}{min((I_{avg}+I_{load1}), I_{max})}$$

$$T_{subsequent} = \sum \frac{Rd_{ln} + HVLoadAh}{min((I_{ln}+I_{load1}), I_{max})} + \sum \frac{Rd_{lm}}{I_{lm}},$$

where $\sum \dfrac{Rd_{ln} + HVLoadAh}{min((I_{ln} + I_{load1}), I_{max})}$ represents the sum of the charging time of respective subsequent stages having the high-power load enabled, and $\sum \dfrac{Rd_{lm}}{I_{lm}}$ represents the sum of the charging time of respective subsequent stages not having the high-power load enabled.

Further, the high-power load being the air conditioner is taken as an example for illustration.

Assuming that a current SOC of the battery is 0% and the battery is being charged. When the charging current stabilizes, the charging current requested by the BMS is 150A, the actual charging current of the battery detected by the BMS is 99A, and a configuration parameter of the charging pile (the maximum output current $I_{max}$ of the charging pile) is 100A. The charging current table of the battery is as follows.

Charging current table of the battery

| | 0-50% | 50%-60% | 60%-70% | 70%-80% | 80%-90% | 90%-100 % |
|---|---|---|---|---|---|---|
| -20<Temp<-10 | 20 | 20 | 20 | 20 | 20 | 10 |
| -10≤Temp<0 | 40 | 40 | 40 | 40 | 40 | 10 |
| 0≤Temp<5 | 60 | 60 | 60 | 60 | 60 | 10 |
| 10≤Temp<20 | 80 | 80 | 80 | 80 | 80 | 10 |
| 20≤Temp<45 | 150 | 130 | 120 | 110 | 100 | 20 |
| 45≤Temp<55 | 80 | 80 | 80 | 80 | 80 | 20 |
| 55≤Temp<60 | 20 | 20 | 20 | 20 | 20 | 20 |

The first row displays charging stages and is represented by the range of the SOC, and the first column displays temperature ranges (unit: degrees Celsius) of the battery. An intersection of each row and each column except the first row and the first column represents a requested charging current (unit: ampere) of the charging stage in the temperature range of the battery.

Assuming that a current in-vehicle temperature (InCarT) is 35°C, a target temperature (ACPTargetT) of the air conditioner is 25°C, a temperature drop rate DownTSp (min/°C) obtained by a pre-test calibration is 0.025 h/°C, an out-vehicle temperature (OutCarT) is 35°C, a time interval PeriodT of turning on the air conditioner is 0.25h, an average current HVLoadAh when the air conditioner is turned on is 10A, and high-power cooling is re-started when it is detected that the in-vehicle temperature is 3 °C higher than the temperature outside the vehicle (ACPReStartT), then the calculation method of the remaining time of the charging is as follows.

A. From the charging current table, a stage in which "the charging current requested by a certain stage plus the average current when the air conditioner is turned on $\geq I_{max}$", i.e., "an allowable charging current of the battery + a current consumed by the load > an output capacity of the charging pile" can be found. The current consumed by the load in this part needs to be used as the ampere hours of the battery to calculate the remaining time of the charging. From the table, it can be found that this part is a part SOC 0-90%. After the load is enabled in this part, an estimation of the remaining time of the charging will be affected.

B. A period (FirstCIT) required to lower the in-vehicle temperature to the target temperature is calculated by First-CIT=(InCarT-ACPTargetT)*DownTSp=0.25h.

C. An on-period (ACPThoux) after restarting the air conditioner due to a difference between the target temperature and the out-vehicle temperature is calculated as:

$$ACPThoux = (\frac{(AFChrgT - FirstClT - PeriodT)}{PeriodT + DownTSp \times ACPReStartT} \times ACPReStartT)$$

$$= 0.15$$

D. A total on-period of the air conditioner = 0.4h

E. A number of cumulative impacted ampere hours=0.4* 10=4AH

F. The remaining time of the charging is calculated based on the above determined impacted range SOC (0-90%) and the number of ampere hours required by the load:

$$T_{underpower\ with\ load\ enabled} = T_{current} + T_{subsequent}$$

$$T_{current} = \frac{Rd_c + HVLoadAh}{min((I_{avg} + I_{load1}), I_{max})} = 0.516$$

$$T_{subsequent} = \sum \frac{Rd_{ln} + HVLoadAh}{min((I_{ln} + I_{load1}), I_{max})} + \sum \frac{Rd_{lm}}{I_{lm}} = 1.016$$

$$T_{\text{underpower with load enabled}} = T_{\text{current}} + T_{\text{subsequent}} = 1.532$$

$$T_{\text{underpower}} = T_{\text{current}} + T_{\text{susequent}}$$

$$T_{\text{current}} = \frac{\text{a number of charging ampere hours required by a current stage} + \text{a number of ampere hours required by the power load in the current stage}}{\min(\text{average current, maximum output current of the charging pile})}$$

$$= \frac{(SOC_{\text{currentEnd}} - SOC_{\text{current}}) \times (RdAh + HVLoadAh)}{\min(Iavg, I_{\max})}$$

$$= 0.516$$

$$T_{\text{subsequent}} = \sum \frac{\text{number of charging ampere hours required at a stage having power load enabled} + \text{number of ampere hours required by power load at the current stage}}{\min(\text{a requested current of charging at a stage, maximum output current of charging pile})} +$$

$$\sum \frac{\text{a number of charging ampere hours required at a stage not having power load enabled}}{\min(\text{a requested current of charging at a stage, maximum output current of charging pile})}$$

$$= \frac{\Delta SOC_{\text{subsequent load-enabled 1}} \times (RdAh + HVLoadAh)}{\min(I_{\text{subsequent load-enabled 1}}, I_{\max})}$$

$$+ \frac{\Delta SOC_{\text{subsequent load-enabled 2}} \times (RdAh + HVLoadAh)}{\min(I_{\text{subsequent load-enabled 2}}, I_{\max})} \ldots +$$

$$\frac{\Delta SOC_{\text{subsequent load-enabled n}} \times (RdAh + HVLoadAh)}{\min(I_{\text{subsequent load-enabled n}}, I_{\max})}$$

$$+ \frac{\Delta SOC_{\text{subsequent load-not enabled 1}} \times RdAh}{\min(I_{\text{subsequent load-not enabled 1}}, I_{\max})} = 1.016$$

$$T_{\text{underpower}} = T_{\text{current}} + T_{\text{subsequent}} = 0.516 + 1.016 = 1.532$$

Sub-case B: the dynamic change mode with the high-power load

In this state, the output power of the charging pile is in a state of change and the duration of the output power is uncertain. In an embodiment of the present disclosure, in order to calculate the remaining time of the charging more accurately, the average current of the charging pile is obtained first, and then the remaining time of the charging is calculated based on the average current of the charging pile. Specifically, the average current of the charging pile can be obtained in the following manner.

The average current value of the charging pile in the time period of T1 is obtained as the average current $I_{\text{avgpret}}$

of the charging pile in response to the duration of $I_p - M_1 > I_1$ exceeding T1 during the charging, where $I_p$ represents the charging current requested by the BMS, $M_1$ represents the current of the charging pile, $I_1$ represents the first predetermined current threshold, and T1 represents the first predetermined time threshold.

In the above state, the high-power load is enabled, and thus parameter adjustments in this case include: adjusting $Rd_c$ to $Rd_{c5}$, wherein $Rd_{cs}$ is specifically expressed as: $Rd_{c5} = Rd_c + HVLoadAh$, where HVLoadAh represents the number of ampere hours required by the high-power load during the charging; adjusting $Rd_{ln}$ at the stage having the high-power load enabled to $Rd_{lns}$, where $Rd_{ln5}$ is specifically expressed as: $Rd_{ln5} = Rd_{ln} + HVLoadAh$; adjusting $I_{avg}$ to $I_{avg5}$, where $I_{avg5}$ is specifically expressed as: $I_{avg5} = min((I_{avg} + I_{load1}), I_{avgpret})$; and adjusting $I_{ln}$ at the stage having the high-power load enabled to $I_{ln5}$, where $I_{ln5}$ is specifically expressed as: $I_{ln5} = min((I_{ln} + I_{load1}), I_{avgpret})$, wherein $I_{load1}$ represents the working current of the high-power load, $min((I_{avg} + I_{load1}), I_{avgpret})$ represents a smaller one of $(I_{avg} + I_{load1})$ and $I_{avgpret}$; and $min((I_{ln} + I_{load1}), I_{avgpret})$ represents a smaller one of $(I_{ln} + I_{load1})$ and $I_{avgpret}$.

The remaining time of the charging in this case can be specifically expressed as:

$$T_{dynamic\ power\ change\ with\ load\ enabled} = T_{current} + T_{subsequent}$$

$$T_{current} = \frac{Rd_c + HVLoadAh}{min((I_{avg} + I_{load1}), I_{avgpret})}$$

$$T_{subsequent} = \sum \frac{Rd_{ln} + HVLoadAh}{min((I_{ln} + I_{load1}), I_{avgpret})} + \sum \frac{Rd_{lm}}{I_{lm}},$$

where $\sum \dfrac{Rd_{1n} + HVLoadAh}{min\ (\ (I_{1n} + I_{load1})\ ,\ I_{avgpret})}$ represents a sum of charging time of respective subsequent stages having the high-power load enabled, and $\sum \dfrac{Rd_{1m}}{I_{1m}}$ represents a sum of charging time of respective subsequent stages not having the high-power load enabled.

Sub-case C: failure mode with the high-power load

Parameter adjustments in this case include: adjusting $Rd_c$ to $Rd_{c6}$, wherein $Rd_{c6}$ is specifically expressed as: $Rd_{c6} = Rd_c + HVLoadAh$, where HVLoadAh represents the number of ampere hours required by the high-power load during the charging; adjusting $Rd_{ln}$ at the stage having the high-power load enabled to $Rd_{ln6}$, where $Rd_{ln6}$ is specifically expressed as: $Rd_{ln6} = Rd_{ln} + HVLoadAh$; adjusting $I_{avg}$ to $I_{avg6}$, where $I_{avg6}$ is specifically expressed as: $I_{avg6} = min((I_{avg} + I_{load1}), I_{max})$; and adjusting $I_{ln}$ at the stage having the high-power load enabled to $I_{ln6}$, where $I_{ln6}$ is specifically expressed as: $I_{ln6} = min((I_{ln} + I_{load1}), I_{max}) * AddCf$, wherein $I_{max}$ represents the maximum output current of the charging pile, $I_{load1}$ represents the working current of the high-power load, AddCf represents the failure adjustment coefficient, $min((I_{avg} + I_{load1}), I_{max})$ represents a smaller one of $(I_{avg} + I_{load1})$ and $I_{max}$, and $min((I_{ln} + I_{load1}), I_{max})$ represents a smaller one of $(I_{ln} + I_{load1})$ and $I_{max}$.

The remaining time of the charging in this case can be specifically expressed as:

$$T_{load\ enabled\ with\ a\ failure\ limiting\ the\ current} = T_{current} + T_{subsequent}$$

$$T_{current} = \frac{Rd_c + HVLoadAh}{min((I_{avg} + I_{load1}), I_{max})}\ ,$$

$$T_{subsequent} = \sum \frac{Rd_{ln} + HVLoadAh}{min((I_{ln} + I_{load1}), I_{max}) * AddCf} + \sum \frac{Rd_{lm}}{I_{lm} * AddCf}$$

where $\sum \dfrac{Rd_{1n} + HVLoadAh}{\min\ (\ (I_{1n} + I_{load})\ ,\ I_{max})\ *\ AddCf}$ represents a sum of charging time of respective subsequent stages having the high-power load enabled, and $\sum \dfrac{Rd_{1m}}{I_{1m}}$ represents a sum of charging time of respective subsequent stages not having the high-power load enabled.

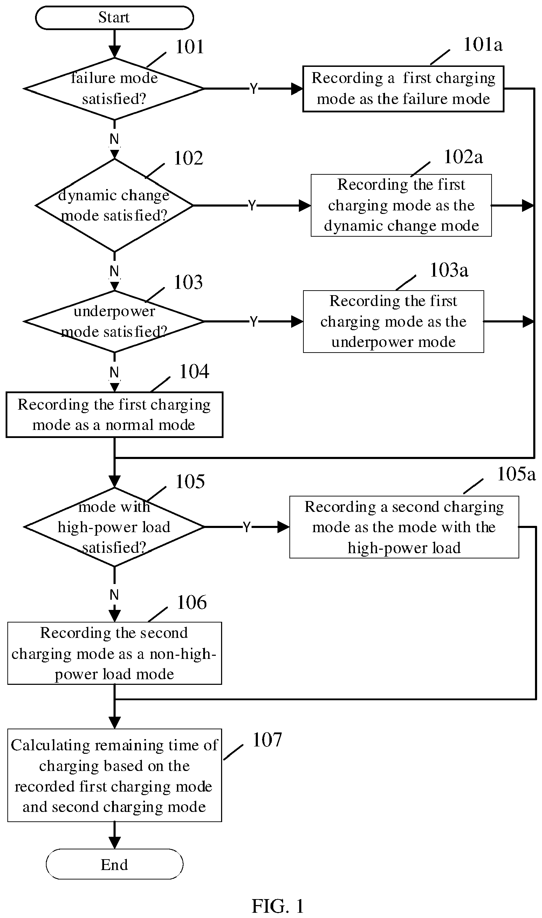

In addition to providing specific calculation methods of the remaining time of the charging in various situations, an embodiment of the present disclosure also provides a calculation method of the remaining time of the charging when different situations may co-exist in reality. FIG. 1 is a flowchart illustrating a method for calculating remaining time of charging according to an embodiment of the present disclosure. As illustrated in FIG. 1, the method includes the following steps.

At step 101, whether the failure mode is satisfied is determined.

A charging failure may be caused by a variety of reasons. After a charging failure occurs, the charging current is usually limited by a certain percentage.

That is, compared with a normal charging state, the charging current will be adjusted according to the certain percentage when calculating the remaining time of the charging in the failure mode.

At step 101a, when it is determined at step 101 that the current charging mode is the failure mode, a first charging mode is recorded as the failure mode, and the method proceeds to step 105.

At step 102, when it is determined at step 101 that the current charging mode is not the failure mode, whether the dynamic change mode is satisfied is determined.

In the dynamic change mode, the output power of the charging pile is in a state of change, and the duration of the output power is uncertain. Therefore, when the remaining time of the charging is calculated, an actual charging current will be adjusted with reference to an average charging current over a period of time.

At step 102a, when it is determined at step 102 that the current charging mode is the dynamic change mode, the first charging mode is recorded as the dynamic change mode, and the method proceeds to step 105.

At step 103, when it is determined at step 102 that the current charging mode is not the dynamic change mode, whether the underpower mode is satisfied is determined.

In the underpower mode, the output power of the charging pile cannot meet the charging current requested by the BMS. When calculating the actual charging time, the requested current for charging in a certain stage should be compared with the current that the charging pile can provide, and if the requested current exceeds the current that the charging pile can provide, the current that the charging pile can provide is determined as the actual charging current.

That is, compared with the normal charging state, the charging current will be adjusted according to the current that the charging pile can provide when calculating the remaining time of the charging in the underpower mode.

At step 103a, when it is determined at step 103 that the current charging mode is the underpower mode, the first charging mode is recorded as the underpower mode, and the method proceeds to step 105.

At step 104, when it is determined at step 103 that the current charging mode is not the underpower mode, the first charging mode is recorded as the normal mode.

Three common abnormal charging modes are the failure mode, the dynamic change mode, and the underpower mode. When it is determined through the above steps that the current charging mode does not belong to any of the three common abnormal charging modes, the current charging mode is determined to be the normal mode.

In the normal mode, normal charging is usually performed based on the required number of ampere hours and the requested charging current, and the remaining time of the charging is also calculated based on the required number of ampere hours and the requested charging current.

At step 105, whether the mode with the high-power load is satisfied is determined.

Normally, the high-power load may include, e.g., the air conditioner or other high-power electrical appliances. A case of enabling the high-power load during the charging may be that, a difference between the in-vehicle temperature and the temperature desired by the user is large, and thus the air conditioner needs to be operated with a high power.

In this state, the required number of ampere hours and the requested charging current for the charging will be affected by the high-power load and thus need to be adjusted. The remaining time of the charging is also calculated based on the adjusted required number of ampere hours and the adjusted requested charging current for the charging.

At step 105a, when it is determined at step 105 that the current charging mode is the mode with the high-power load, a second charging mode is recorded as the mode with the high-power load.

At step 106, when it is determined at step 105 that the current charging mode is not the mode with the high-power load, the second charging mode is recorded as a non-high-power load mode.

In this state, the remaining time of the charging is calculated without the influence of the high-power load.

At step 107, the remaining time of the charging is calculated based on the recorded first charging mode and second charging mode.

As mentioned above, the first charging mode is one of the failure mode, the dynamic change mode, the underpower mode and the normal mode, and the second charging mode is one of the mode with the high-power load and the non-high-power load mode. The remaining time of the charging is calculated based on the first charging mode and the second charging mode. Specifically, the required number of ampere hours or the charging current is adjusted based on the specific first charging mode and second charging mode to calculate the remaining time of the charging.

From the above description of the embodiments of the present disclosure, it can be seen that in an embodiment of the present disclosure, a plurality of charging modes is recognized, and at least one parameter is adjusted in accordance with different modes in order to calculate the remaining time of the charging, such that the calculation result of the remaining time of the charging is more accurate. Further, according to degrees of influence of different modes (the failure mode, the dynamic change mode, the underpower mode) on the remaining time of the charging, the modes are prioritized. Whether these predetermined modes are met is sequentially determined, and a determination of priority may be given priority as a mode determination result, such that the accuracy of the result can be better improved. In addition, the mode with the high-power load is determined separately, such that the result of the charging mode is more accurate, and the accuracy of the result is greatly improved.

The above method for calculating the remaining time of the charging can be summarized as: sequentially determining whether a first charging mode is a failure mode, a dynamic change mode, or an underpower mode; if it is determined that the current charging mode is one of the failure mode, the dynamic change mode, and the underpower mode, recording the first charging mode as the determined charging mode; if it is determined that the current charging mode is not one of the failure mode, the dynamic change mode, and the underpower mode, recording the first charging mode as a normal mode; determining whether the current charging mode is a mode with a high-power load; if it is determined that the current charging mode is the mode with the high-power load, recording a second charging mode as the mode with the high-power load; if it is determined that the current charging mode is not the mode with the high-power load, recording the second charging mode as a non-high-power load mode; and calculating the remaining time of the charging based on the first charging mode and the second charging mode, wherein the remaining time of the charging is calculated based on the adjusted charging current when the first charging mode includes any one of the failure mode, the dynamic change mode, and the underpower mode, and the remaining time of the charging is calculated based on the adjusted number of charging ampere hours and charging current when the second charging mode includes the mode with the high-power load.

Through the design of the above method process, firstly, priorities of the failure mode, the dynamic change mode, the underpower mode, and the normal mode are sorted in a certain order. A mode with a higher priority is determined as a basis for calculating the remaining time of the charging, for the reason that the mode with the higher priority is more in line with requirements of an actual use environment of the battery, and the calculated remaining time is more consistent with a real situation. Secondly, the mode with the high-power load is used as a mode that must be determined whether to be participated in the calculation, such that the calculation result is more accurate and meets requirements of an actual environment.

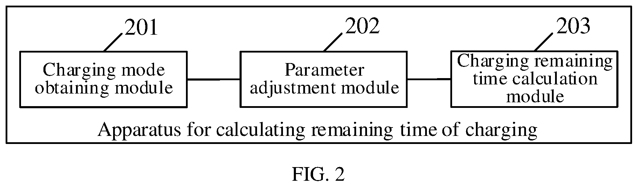

An embodiment of the present disclosure also provides an apparatus for calculating remaining time of charging. FIG. 2 is a block diagram showing an apparatus for calculating remaining time of charging according to an embodiment of the present disclosure. As illustrated in FIG. 2, the charging includes at least one charging stage. The apparatus includes a charging mode obtaining module 201, a parameter adjustment module 202, and a charging remaining time calculation module 203.

The charging mode obtaining module 201 is configured to obtain a charging mode.

The parameter adjustment module 202 is configured to adjust at least one of $Rd_c$, $I_{avg}$, $Rd_{In}$, or $I_{In}$ based on the obtained charging mode, where $Rd_c$ represents a number of charging ampere hours required to charge a battery in a current charging stage, $I_{avg}$ represents an average current requested to charge the battery in the current charging stage, $Rd_{In}$ represents a number of charging ampere hours required to charge the battery in a subsequent n-th charging stage, and $I_{In}$ represents a requested current requested to charge the battery in the subsequent n-th charging stage.

The charging remaining time calculation module 203 is configured to calculate the remaining time of the charging by $T = \dfrac{Rd_c}{I_{avg}} + \sum \dfrac{Rd_{1n}}{I_{1n}}$, where T represents the remaining time of the charging, $\dfrac{Rd_c}{I_{avg}}$ represents charging time of the current charging stage, $\dfrac{Rd_{1n}}{I_{1n}}$ represents charging time of the subsequent n-th charging stage, and $\sum \dfrac{Rd_{1n}}{I_{1n}}$ represents charging time of all subsequent charging stages.

An embodiment of the present disclosure also discloses a computer-readable storage medium having a computer program stored thereon. The computer program causes a computer to perform any of the above methods for calculating the remaining time of the charging.

Those skilled in the art can understand that all or part of the steps in various methods of the above embodiments can be implemented by a program instructing relevant hardware. The program can be stored in a computer-readable storage medium. The storage medium includes a Read-Only Memory (ROM), a Random Access Memory (RAM), a Programmable Read-only Memory (PROM), an Erasable Programmable Read Only Memory (EPROM), a One-time Programmable Read-Only Memory (OTPROM), an Electronically-Erasable Programmable Read-Only Memory (EEPROM), a Compact Disc Read-Only Memory (CD-ROM) or other compact disk memory, a magnetic disk memory, a tape memory, or any other computer-readable medium that can be used to carry or store data.

The method and apparatus for calculating the remaining time of the charging, and the storage medium disclosed in the embodiments of the present disclosure have been described in detail above. Specific examples are used herein to illustrate the principle and implementations of the present disclosure. The above description of the embodiments is only used to help understand the method and the invention.

**Claims**

1. A method for calculating remaining time of charging of a battery, the charging comprising at least one charging stage, the method for calculating the remaining time of the charging comprises:

   obtaining a charging mode and adjusting at least one of $Rd_c$, $I_{avg}$, Rdin, or $I_{ln}$ based on the charging mode, where $Rd_c$ represents a number of charging ampere hours required to charge the battery in a current charging stage, $I_{avg}$ represents an average current requested to charge the battery in the current charging stage, Rdin represents a number of charging ampere hours required to charge the battery in a subsequent n-th charging stage, and $I_{ln}$ represents a requested current requested to charge the battery in the subsequent n-th charging stage; and

   calculating the remaining time of the charging by $$T = \frac{Rd_c}{I_{avg}} + \sum \frac{Rd_{ln}}{I_{ln}},$$

   where T represents the remaining time of the charging, $\frac{Rd_c}{I_{avg}}$ represents charging time of the current charging stage, $\frac{Rd_{ln}}{I_{ln}}$ represents charging time of the subsequent n-th charging stage, and $\sum \frac{Rd_{ln}}{I_{ln}}$ represents charging time of all subsequent charging stages, wherein said obtaining the charging mode and said adjusting the at least one of $Rd_c$, $I_{avg}$, $Rd_{ln}$, or $I_{ln}$ based on the charging mode comprise:

   obtaining a dynamic change mode as the charging mode, and adjusting Iin to $I_{ln2}$ based on the dynamic change mode, wherein
   $I_{ln2}$ is obtained by: $I_{ln2} = \min(I_{ln}, I_{avgpret})$, where $I_{avgpret}$ represents an average current value of a charging pile, and $\min(I_{ln}, I_{avgpret})$ represents a smaller one of $I_{ln}$ and $I_{avgpret}$;
   $I_{avgpret}$ is obtained by: obtaining the average current value of the charging pile in a time period of T1 as $I_{avgpret}$ in response to a duration of $I_p - M_1 > I_1$ exceeding T1 during the charging, where $I_p$ represents a charging current requested by a battery management system, BMS, $M_1$ represents a current of the charging pile, $I_1$ represents a first predetermined current threshold, and T1 represents a first predetermined time threshold; and
   the dynamic change mode is a state in which the duration of $I_p - M_1 > I_1$ exceeds T1 during the charging.

2. The method for calculating the remaining time of the charging of a battery according to claim 1, wherein said obtaining the charging mode and said adjusting the at least one of $Rd_c$, $I_{avg}$, Rdin, or $I_{ln}$ based on the charging mode comprise:

   obtaining a mode with a high-power load as the charging mode, and adjusting $Rd_c$ to $Rd_{cs}$ based on the mode with the high-power load, wherein $Rd_{cs}$ is expressed as: $Rd_{cs} = Rd_c + HVLoadAh$, where HVLoadAh represents a number of ampere hours required by the high-power load during the charging;

adjusting $Rd_{ln}$ at a stage having the high-power load enabled to $Rd_{lns}$, where $Rd_{lns}$ is expressed as: $Rd_{lns}=Rd_{ln}+HVLoadAh$; and

adjusting lin at the stage having the high-power load enabled to $I_{lns}$, where $I_{lns}$ is expressed as: $I_{lns}=I_{ln}+I_{load}$, where $I_{load}$ represents a working current for the high-power load.

**3.** The method for calculating the remaining time of the charging of a battery according to claim 1, wherein said obtaining the charging mode and said adjusting the at least one of $Rd_c$, $I_{avg}$, Rdin, or $I_{ln}$ based on the charging mode comprise:

obtaining an underpower mode as the charging mode, and adjusting $I_{avg}$ to $I_{avg1}$ based on the underpower mode, wherein $I_{avg1}$ is expressed as: $I_{avg1}=min(I_{avg}, I_{max})$; and

adjusting $I_{ln}$ to $I_{ln1}$, wherein $I_{ln1}$ is expressed as: $I_{ln1}= min(I_{ln}, I_{max})$,

wherein $I_{max}$ represents a maximum output current of a charging pile, min $(I_{avg}, I_{max})$ represents a smaller one of $I_{avg}$ and $I_{max}$, min $(I_{ln}, I_{max})$ represents a smaller one of $I_{ln}$ and $I_{max}$, and the underpower mode is a mode in which $I_{avg}$ or $I_{ln}$ is greater than $I_{max}$ in the at least one stage.

**4.** The method for calculating the remaining time of the charging of a battery according to claim 1, wherein said obtaining the charging mode and said adjusting the at least one of $Rd_c$, $I_{avg}$, Rdin, or $I_{ln}$ based on the charging mode comprise:

obtaining a failure mode as the charging mode, and adjusting $I_{avg}$ to $I_{avg3}$ based on the failure mode, wherein $I_{avg3}$ is expressed as: $I_{avg3}=min(I_{avg}, I_{max})$; and

adjusting $I_{ln}$ to $I_{ln3}$, wherein $I_{ln3}$ is expressed as: $I_{ln3}= min(I_{ln}, I_{max})*AddCf$,

wherein $I_{max}$ represents a maximum output current of a charging pile, AddCf represents a failure adjustment coefficient, min $(I_{avg}, I_{max})$ represents a smaller one of $I_{avg}$ and $I_{max}$, and min $(I_{ln}, I_{max})$ represents a smaller one of $I_{ln}$ and $I_{max}$,

wherein the failure mode is a state in which the charging current is limited.

**5.** The method for calculating the remaining time of the charging of a battery according to claim 1, wherein said obtaining the charging mode, and adjusting the at least one of $Rd_c$, $I_{avg}$, Rdin, or $I_{ln}$ based on the charging mode comprise:

obtaining an underpower mode with a high-power load as the charging mode, and performing, based on the underpower mode with the high-power load, adjustments comprising:

adjusting $Rd_c$ to $Rd_{c4}$, wherein $Rd_{c4}$ is expressed as: $Rd_{c4}=Rd_c+HVLoadAh$, where HVLoadAh represents a number of ampere hours required by the high-power load during the charging;

adjusting $Rd_{ln}$ at a stage having the high-power load enabled to $Rd_{ln4}$, wherein $Rd_{ln4}$ is expressed as: $Rd_{ln4}=Rd_{ln}+HVLoadAh$;

adjusting $I_{avg}$ to $I_{avg4}$, wherein $I_{avg4}$ is expressed as: $I_{avg4}=min((I_{avg}+I_{load1}), I_{max})$; and

adjusting $I_{ln}$ at a stage having the high-power load enabled to $I_{ln4}$, wherein $I_{ln4}$ is expressed as:

$$I_{ln4}= min((I_{ln}+I_{load1}), I_{max}),$$

wherein $I_{max}$ represents a maximum output current of a charging pile, and $I_{load1}$ represents a working current for the high-power load, min$((I_{avg}+I_{load1}), I_{max})$ represents a smaller one of $(I_{avg}+I_{load1})$ and $I_{max}$, and min$((I_{ln}+I_{load1}), I_{max})$ represents a smaller one of $(I_{ln}+I_{load1})$ and $I_{max}$; and

wherein in the underpower mode with the high-power load, the high-power load is enabled and in at least one stage of the charging, $(I_{avg}+I_{load1})$ or $(I_{ln}+I_{load1})$ is greater than $I_{max}$.

**6.** The method for calculating the remaining time of the charging of a battery according to claim 1, wherein said obtaining the charging mode and said adjusting the at least one of $Rd_c$, $I_{avg}$, $Rd_{ln}$, or $I_{lm}$ based on the charging mode comprise:

sequentially determining (101; 102; 103) whether a current charging mode is a failure mode, the dynamic change mode, or an underpower mode;

if it is determined that the current charging mode is one of the failure mode, the dynamic change mode, and the underpower mode, recording (101a; 102a; 103a) a first charging mode as the determined charging mode;

if it is determined that the current charging mode is not one of the failure mode, the dynamic change mode, and the underpower mode, recording (104) the first charging mode as a normal mode;
determining (105) whether the current charging mode is a mode with a high-power load;
if it is determined that the current charging mode is the mode with the high-power load, recording (105a) a second charging mode as the mode with the high-power load;
if it is determined that the current charging mode is not the mode with the high-power load, recording (106) the second charging mode as a non-high-power load mode;
determining the recorded first charging mode and the recorded second charging mode as the charging mode; and
adjusting the at least one of $Rd_c$, $I_{avg}$, $Rd_{In}$, or $I_{In}$ based on the charging mode,
wherein the failure mode is a state in which the charging current is limited;
wherein in the underpower mode, the output power of the charging pile does not meet the charging current requested by the BMS; and
wherein calculating the remaining time of the charging comprises:

calculating the remaining time of the charging based on the first charging mode and the second charging mode,
wherein the remaining time of the charging is calculated based on the charging current adjusted in accordance with the normal mode when the first charging mode comprises any one of the failure mode, the dynamic change mode, and the underpower mode, and the remaining time of the charging is calculated based on a number of charging ampere hours and the charging current that are adjusted in accordance with the normal mode when the second charging mode comprises the mode with the high-power load.

7. An apparatus for calculating remaining time of charging of a battery, the charging comprising at least one charging stage, the apparatus comprising:

a charging mode obtaining module (201) configured to obtain a charging mode;
a parameter adjustment module (202) configured to adjust at least one of $Rd_c$, $I_{avg}$, $Rd_{In}$, or $I_{In}$ based on the obtained charging mode, where $Rd_c$ represents a number of charging ampere hours required to charge the battery in a current charging stage, $I_{avg}$ represents an average current requested to charge the battery in the current charging stage, $Rd_{In}$ represents a number of charging ampere hours required to charge the battery in a subsequent n-th charging stage, and $I_{In}$ represents a requested current requested to charge the battery in the subsequent n-th charging stage; and
a charging remaining time calculation module (203) configured to calculate the remaining time of the charging

by $T = \dfrac{Rd_c}{I_{avg}} + \sum \dfrac{Rd_{In}}{I_{In}}$, where T represents the remaining time of the charging, $\dfrac{Rd_c}{I_{avg}}$ represents charging time of the current charging stage, $\dfrac{Rd_{In}}{I_{In}}$ represents charging time of the subsequent n-th charging stage, and

$\sum \dfrac{Rd_{In}}{I_{In}}$ represents charging time of all subsequent charging stages,
wherein the charging mode obtaining module (201) is further configured to obtain a dynamic change mode as the charging mode; and
wherein the parameter adjustment module (202) is further configured to adjust $I_{In}$ to $I_{In2}$ based on the dynamic change mode, wherein:

$I_{In2}$ is obtained by: $I_{In2}= min(I_{In}, I_{avgpret})$, where $I_{avgpret}$ represents an average current value of a charging pile, and $min(I_{In}, I_{avgpret})$ represents a smaller one of $I_{In}$ and $I_{avgpret}$;
$I_{avgpret}$ is obtained by: obtaining the average current value of the charging pile in a time period of T1 as $I_{avgpret}$ in response to a duration of $I_p-M_1>I_1$ exceeding T1 during the charging, where $I_p$ represents a charging current requested by a battery management system (BMS), $M_1$ represents a current of the charging pile, $I_1$ represents a first predetermined current threshold, and T1 represents a first predetermined time threshold; and
wherein the dynamic change mode is a state in which the duration of $I_p -M_1>I_1$ exceeds T1 during the charging.

8. A computer-readable storage medium having a computer program stored thereon, the computer program causing an apparatus according to claim 7 to perform the method for calculating the remaining time of the charging according to any one of claims 1 to 6.

**Patentansprüche**

1. Verfahren zum Berechnen der verbleibenden Zeit des Ladens einer Batterie, wobei das Laden mindestens eine Ladestufe umfasst, wobei das Verfahren zum Berechnen der verbleibenden Ladezeit Folgendes beinhaltet:

   Ermitteln eines Lademodus und Einstellen von mindestens einem von $Rd_c$, $I_{avg}$, $Rd_{In}$ oder $I_{In}$ auf der Basis des Lademodus, wobei $Rd_c$ eine Anzahl von Ladeampere-Stunden darstellt, die erforderlich sind, um die Batterie in einer aktuellen Ladestufe zu laden, $I_{avg}$ einen durchschnittlichen Strom darstellt, der angefordert wird, um die Batterie in der aktuellen Ladestufe zu laden, $Rd_{In}$ eine Anzahl von Lade-Ampere-Stunden darstellt, die erforderlich sind, um die Batterie in einer nachfolgenden n-ten Ladestufe zu laden, und $I_{In}$ einen angeforderten Strom darstellt, der angefordert wird, um die Batterie in der nachfolgenden n-ten Ladestufe zu laden; und

   Berechnen der verbleibenden Ladezeit durch $$T = \frac{Rd_c}{I_{avg}} + \sum \frac{Rd_{In}}{I_{In}},$$

   wobei T die verbleibende Ladezeit darstellt, $\dfrac{Rd_c}{I_{avg}}$ die Ladezeit der aktuellen Ladestufe darstellt, $\dfrac{Rd_{In}}{I_{In}}$ die Ladezeit der nachfolgenden n-ten Ladestufe darstellt und $\sum \dfrac{Rd_{In}}{I_{In}}$ die Ladezeit aller nachfolgenden Ladestufen darstellt,

   wobei das genannte Ermitteln des Lademodus und das genannte Einstellen von dem mindestens einen von $Rd_c$, $I_{avg}$, $Rd_{In}$ oder $I_{In}$ auf der Basis des Lademodus Folgendes beinhalten:

      Ermitteln eines dynamischen Änderungsmodus als den Lademodus, und Einstellen von $I_{In}$ auf $I_{In2}$ auf der Basis des dynamischen Änderungsmodus, wobei

      $I_{In2}$ ermittelt wird durch: $I_{In2}= min(I_{In}, I_{avgpret})$, wobei $I_{avgpret}$ einen durchschnittlichen Stromwert einer Ladesäule darstellt, und $min(I_{In}, I_{avgpret})$ einen kleineren Wert von $I_{In}$ und $I_{avgpret}$ darstellt;

      $I_{avgpret}$ ermittelt wird durch: Ermitteln des durchschnittlichen Stromwertes der Ladesäule in einer Zeitperiode von Tl als $I_{avgpret}$ als Reaktion darauf, dass eine Dauer von $I_p$ - $M_1 > I_l$ während des Ladens Tl überschreitet, wobei $I_p$ einen von einem Batteriemanagementsystem, BMS, angeforderten Ladestrom darstellt, $M_1$ einen Strom der Ladesäule darstellt, einen ersten vorbestimmten Stromschwellenwert darstellt und Tl einen ersten vorbestimmten Zeitschwellenwert darstellt; und

      der dynamische Änderungsmodus ein Zustand ist, in dem die Dauer von $I_p$ - $M_1 > I_l$, während des Ladens T1 überschreitet.

2. Verfahren zum Berechnen der verbleibenden Zeit des Ladens einer Batterie nach Anspruch 1, wobei das genannte Ermitteln des Lademodus und das genannte Einstellen von dem mindestens einen von $Rd_c$, $I_{awg}$, $Rd_{In}$ oder $I_{In}$ auf der Basis des Lademodus Folgendes beinhalten:

      Ermitteln eines Modus mit einer Hochleistungslast als Lademodus, und Einstellen von $Rd_c$ auf $Rd_{cs}$ auf der Basis des Modus mit der Hochleistungslast, wobei $Rd_c$ ausgedrückt wird als: $Rd_{cs}=Rd_c+HVLoadAh$, wobei HVLoadAh eine Anzahl von Ampere-Stunden darstellt, die von der Hochleistungslast während des Ladens benötigt werden;

      Einstellen von $Rd_{In}$ in einer Stufe, in der die Hochleistungslast eingeschaltet ist, auf $Rd_{Ins}$, wobei $Rd_{Ins}$ ausgedrückt wird als: $Rd_{Ins}=Rd_{In}+HVLoadAh$; und

      Einstellen von $I_{In}$ in der Stufe, in der die Hochleistungslast eingeschaltet ist, auf $I_{Ins}$, wobei $I_{Ins}$ ausgedrückt wird als: $I_{Ins}=I_{In}+I_{load}$, wobei $I_{load}$ einen Arbeitsstrom für die Hochleistungslast darstellt.

3. Verfahren zum Berechnen der verbleibenden Zeit des Ladens einer Batterie nach Anspruch 1, wobei das genannte Ermitteln des Lademodus und das genannte Einstellen von dem mindestens einen von $Rd_c$, $I_{awg}$, $Rd_{In}$ oder $I_{In}$ auf der Basis des Lademodus Folgendes beinhalten:

Ermitteln eines Unterleistungsmodus als den Lademodus und Einstellen von $I_{avg}$ auf $I_{avg1}$ auf der Basis des Unterleistungsmodus, wobei $I_{avg1}$ ausgedrückt wird als: $I_{avg1} = \min(I_{avg}, I_{max})$; und
Einstellen von $I_{ln}$ auf $I_{ln1}$, wobei $I_{ln1}$ ausgedrückt wird als: $I_{ln1} = \min(I_{ln}, I_{max})$,
wobei $I_{max}$ einen maximalen Ausgangsstrom einer Ladesäule darstellt, $\min(I_{avg}, I_{max})$ ein kleineres von $I_{avg}$ und $I_{max}$ darstellt, $\min(I_{ln}, I_{max})$ ein kleineres von $I_{ln}$ und $I_{max}$ darstellt, und der Unterleistungsmodus ein Modus ist, in dem $I_{avg}$ oder $I_{ln}$ größer als $I_{max}$ in der mindestens einen Stufe ist.

4. Verfahren zum Berechnen der verbleibenden Zeit des Ladens einer Batterie nach Anspruch 1, wobei das genannte Ermitteln des Lademodus und das genannte Einstellen von dem mindestens einen von $Rd_c$, $I_{awg}$, $Rd_{ln}$ oder $I_{ln}$ auf der Basis des Lademodus Folgendes beinhalten:

   Ermitteln eines Fehlermodus als den Lademodus, und Einstellen von $I_{avg}$ auf $I_{avg3}$ auf der Basis des Fehlermodus, wobei $I_{avg3}$ ausgedrückt wird als: $I_{avg3} = \min(I_{avg}, I_{max})$; und
   Einstellen von $I_{ln}$ auf $I_{ln3}$, wobei $I_{ln3}$ ausgedrückt wird als: $I_{ln3} = \min(I_{ln}, I_{max}) * AddCf$,
   wobei $I_{max}$ einen maximalen Ausgangsstrom einer Ladesäule darstellt, AddCf einen Fehleranpassungskoeffizienten darstellt, $\min(I_{avg}, I_{max})$ ein kleineres von $I_{avg}$ und $I_{max}$ darstellt, und $\min(I_{ln}, I_{max})$ ein kleineres von $I_{ln}$ und $I_{max}$ darstellt;
   wobei der Fehlermodus ein Zustand ist, in dem der Ladestrom begrenzt ist.

5. Verfahren zum Berechnen der verbleibenden Zeit des Ladens einer Batterie nach Anspruch 1, wobei das genannte Ermitteln des Lademodus und das Einstellen von dem mindestens einen von $Rd_c$, $I_{awg}$, $Rd_{ln}$ und $I_{ln}$ oder der Basis des Lademodus Folgendes beinhalten:
   Ermitteln eines Unterleistungsmodus mit einer Hochleistungslast als Lademodus, und Durchführen von Einstellungen auf der Basis des Unterleistungsmodus mit der Hochleistungslast Folgendes beinhaltet:

   Einstellen von $Rd_c$ auf $Rd_{c4}$, wobei $Rd_{c4}$ ausgedrückt wird als: $Rd_{c4} = Rd_c + HVLoadAh$, wobei HVLoadAh eine Anzahl von Ampere-Stunden darstellt, die von der Hochleistungslast während des Ladens benötigt werden;
   Einstellen von $Rd_{ln}$ in einer Stufe, in der die Hochleistungslast eingeschaltet ist, auf $Rd_{ln4}$, wobei $Rd_{ln4}$ ausgedrückt wird als: $Rd_{ln4} = Rd_{ln} + HVLoadAh$;
   Einstellen von $I_{avg}$ auf $I_{avg4}$, wobei $I_{avg4}$ ausgedrückt wird als: $I_{avg4} = \min((I_{avg} + I_{load1}), I_{max})$; und
   Einstellen von $I_{ln}$ in einer Stufe, in der die Hochleistungslast eingeschaltet ist, auf $I_{ln4}$, wobei $I_{ln4}$ ausgedrückt wird als: $I_{ln4} = \min((I_{ln} + I_{load1}), I_{max})$,
   wobei $I_{max}$ einen maximalen Ausgangsstrom einer Ladesäule darstellt, und $I_{load1}$ einen Arbeitsstrom für die Hochleistungslast darstellt, $\min((I_{avg} + I_{load1}), I_{max})$ ein kleineres von $(I_{avg} + I_{load1})$ und $I_{max}$ darstellt, und $\min((I_{ln} + I_{load1}), I_{max})$ ein kleineres von $(I_{ln} + I_{load1})$ und $I_{max}$ darstellt; und
   wobei im Unterleistungsmodus mit der Hochleistungslast die Hochleistungslast eingeschaltet ist und in mindestens einer Stufe des Ladens $(I_{avg} + I_{load1})$ oder $(I_{ln} + I_{load1})$ größer als $I_{max}$ ist.

6. Verfahren zum Berechnen der verbleibenden Zeit des Ladens einer Batterie nach Anspruch 1, wobei das genannte Ermitteln des Lademodus und das genannte Einstellen von mindestens einem von $Rd_c$, $I_{awg}$, $Rd_{ln}$ und $I_{ln}$ auf der Basis des Lademodus Folgendes beinhalten:

   sequentielles Feststellen (101; 102; 103), ob ein aktueller Lademodus ein Fehlermodus, der dynamische Änderungsmodus oder ein Unterleistungsmodus ist:
   wenn festgestellt wird, dass der aktuelle Lademodus einer von Fehlermodus, dynamischem Änderungsmodus und Unterleistungsmodus ist, Aufzeichnen (101a; 102a; 103a) eines ersten Lademodus als der festgestellte Lademodus;
   wenn festgestellt wird, dass der aktuelle Lademodus keiner von Fehlermodus, dynamischem Änderungsmodus und Unterleistungsmodus ist, Aufzeichnen (104) des ersten Lademodus als normaler Modus;
   Feststellen (105), ob der aktuelle Lademodus ein Modus mit einer hohen Leistungslast ist;
   wenn festgestellt wird, dass der aktuelle Lademodus der Modus mit der Hochleistungslast ist, Aufzeichnen (105a) eines zweiten Lademodus als der Modus mit der Hochleistungslast,
   wenn festgestellt wird, dass der aktuelle Lademodus nicht der Modus mit der Hochleistungslast ist, Aufzeichnen (106) des zweiten Lademodus als Nicht-Hochleistungslastmodus;
   Feststellen des aufgezeichneten ersten Lademodus und des aufgezeichneten zweiten Lademodus als den Lademodus; und
   Einstellen von dem mindestens einen von $Rd_c$, $I_{awg}$, $Rd_{ln}$ oder $I_{ln}$ auf der Basis des Lademodus,
   wobei der Fehlermodus ein Zustand ist, in dem der Ladestrom begrenzt ist;

wobei im Unterleistungsmodus die Ausgangsleistung der Ladesäule nicht dem vom BMS angeforderten Ladestrom entspricht; und
wobei das Berechnen der verbleibenden Ladezeit Folgendes beinhaltet:

Berechnen der verbleibenden Ladezeit auf der Basis des ersten Lademodus und des zweiten Lademodus, wobei die verbleibende Ladezeit auf der Basis des Ladestroms berechnet wird, eingestellt gemäß dem Normalmodus, wenn der erste Lademodus eines von Fehlermodus, dynamischem Änderungsmodus oder Unterleistungsmodus umfasst, und die verbleibende Ladezeit auf der Basis einer Anzahl von Lade-Ampere-Stunden und des Ladestroms berechnet wird, die gemäß dem Normalmodus eingestellt werden, wenn der zweite Lademodus den Modus mit der Hochleistungslast umfasst.

7. Vorrichtung zum Berechnen der verbleibenden Zeit des Ladens einer Batterie, wobei das Laden mindestens eine Ladestufe umfasst, wobei die Vorrichtung Folgendes umfasst:

ein Lademodusermittlungsmodul (201), das zum Ermitteln eines Lademodus konfiguriert ist;
ein Parametereinstellmodul (202), das zum Einstellen von mindestens einem von $Rd_c$, $I_{awg}$, $Rd_{In}$ oder $I_{In}$ auf der Basis des ermittelten Lademodus konfiguriert ist, wobei $Rd_c$ eine Anzahl von Lade-Ampere-Stunden darstellt, die erforderlich sind, um die Batterie in einer aktuellen Ladestufe zu laden, $I_{avg}$ einen durchschnittlichen Strom darstellt, der angefordert wird, um die Batterie in der aktuellen Ladestufe zu laden, $Rd_{In}$ eine Anzahl von Lade-Ampere-Stunden darstellt, die erforderlich sind, um die Batterie in einer nachfolgenden n-ten Ladestufe zu laden, und $I_{In}$ einen angeforderten Strom darstellt, der angefordert wird, um die Batterie in der nachfolgenden n-ten Ladestufe zu laden; und
ein Laderestzeitberechnungsmodul (203), das zum Berechnen der verbleibenden Ladezeit durch

$$T = \frac{Rd_c}{I_{avg}} + \sum \frac{Rd_{In}}{I_{In}}$$ konfiguriert ist, wobei T die verbleibende Ladezeit darstellt, $\frac{Rd_c}{I_{avg}}$ die Ladezeit der aktuellen Ladestufe darstellt, $\frac{Rd_{In}}{I_{In}}$ die Ladezeit der nachfolgenden n-ten Ladestufe darstellt, und $\sum \frac{Rd_{In}}{I_{In}}$ die Ladezeit aller nachfolgenden Ladestufen darstellt,
wobei das Lademodusermittlungsmodul (201) ferner zum Ermitteln eines dynamischen Änderungsmodus als den Lademodus konfiguriert ist; und
wobei das Parametereinstellmodul (202) ferner zum Einstellen von $I_{In}$ auf $I_{In2}$ auf der Basis des dynamischen Änderungsmodus konfiguriert ist, wobei:

$I_{In2}$ ermittelt wird durch: $I_{In2} = min(I_{In}, I_{avgpret})$, wobei $I_{avgpret}$ einen durchschnittlichen Stromwert einer Ladesäule darstellt, und $min(I_{In}, I_{avgpret})$ ein kleineres von $I_{In}$ und $I_{avgpret}$ darstellt;
$I_{avgpret}$ ermittelt wird durch: Ermitteln des durchschnittlichen Stromwertes der Ladesäule in einer Zeitperiode von T1 als $I_{avgpret}$ als Reaktion darauf, dass eine Dauer von $I_p - M_1 > I_1$ während des Ladens Tl überschreitet, wobei $I_p$ einen von einem Batteriemanagementsystem (BMS) angeforderten Ladestrom darstellt, $M_1$ einen Strom der Ladesäule darstellt, $I_1$ einen ersten vorbestimmten Stromschwellenwert darstellt und Tl einen ersten vorbestimmten Zeitschwellenwert darstellt; und
wobei der dynamische Änderungsmodus ein Zustand ist, in dem die Dauer von $I_p - M_1 > I_1$ während des Ladens Tl überschreitet.

8. Computerlesbares Speichermedium mit einem darauf gespeicherten Computerprogramm, wobei das Computerprogramm eine Vorrichtung nach Anspruch 7 veranlasst, das Verfahren zum Berechnen der verbleibenden Ladezeit nach einem der Ansprüche 1 bis 6 durchzuführen.

**Revendications**

1. Procédé de calcul d'un temps restant de charge d'une batterie, la charge comprenant au moins une phase de charge, le procédé de calcul du temps restant de la charge comprend :

une obtention d'un mode de charge et un ajustement d'au moins un parmi $Rd_c$, $I_{avg}$, $Rd_{In}$, ou $I_{In}$ sur la base du mode de charge, où $Rd_c$ représente un nombre d'ampères-heures de charge requis pour charger la batterie dans une phase de charge actuelle, $I_{avg}$ représente un courant moyen demandé pour charger la batterie dans la phase de charge actuelle, $Rd_{In}$ représente un nombre d'ampères-heures de charge requis pour charger la batterie dans une nième phase de charge subséquente, et $I_{In}$ représente un courant demandé demandé pour charger la batterie dans la nième phase de charge subséquente, et

un calcul du temps restant de la charge au moyen de $T = \frac{Rd_c}{I_{avg}} + \sum \frac{Rd_{In}}{I_{In}}$ ,

où T représente le temps restant de la charge, $\frac{Rd_c}{I_{avg}}$ représente un temps de charge de la phase de charge actuelle, $\frac{Rd_{In}}{I_{In}}$ représente un temps de charge de la nième phase de charge subséquente, et $\sum \frac{Rd_{In}}{I_{In}}$ représente un temps de charge de l'ensemble des phases de charge subséquentes,

dans lequel ladite obtention du mode de charge et ledit ajustement de l'au moins un parmi $Rd_c$, $I_{avg}$, $Rd_{In}$, ou $I_{In}$ sur la base du mode de charge comprennent :

une obtention d'un mode de changement dynamique à titre de mode de chargement, et un ajustement de $I_{In}$ à $I_{In2}$ sur la base du mode de changement dynamique, dans lequel $I_{In2}$ est obtenu au moyen de : $I_{In2}$ = $min(I_{In}, I_{avgpret})$, où $I_{avgpret}$ représente une valeur de courant moyenne d'une pile de charge, et $min(I_{In}, I_{avgpret})$ représente un plus petit parmi $I_{In}$ et $I_{avgpret}$ ;
$I_{avgpret}$ est obtenu : au moyen d'une obtention de la valeur de courant moyenne de la pile de chargement dans une période de T1 à titre d'$I_{avgpret}$ en réponse à une durée $I_p$ - $M_1$ > $I_1$ dépassant T1 pendant la charge, où $I_p$ représente un courant de charge demandé par un système de gestion de batterie, BMS, $M_1$ représente un courant de la pile de charge, $I_1$ représente un premier seuil de courant prédéterminé, et T1 représente un premier seuil de temps prédéterminé ; et
le mode de changement dynamique est un état dans lequel la durée de $I_p$ - $M_1$ > $I_1$ dépasse T1 pendant la charge.

**2.** Procédé de calcul du temps restant de la charge d'une batterie selon la revendication 1, dans lequel ladite obtention du mode de charge et ledit ajustement de l'au moins un parmi $Rd_c$, $I_{avg}$, $Rd_{In}$, ou $I_{In}$ sur la base du mode de charge comprennent :

une obtention d'un mode avec une charge haute puissance à titre de mode de charge, et un ajustement de $Rd_c$ à $Rd_c$, sur la base du mode avec la charge haute puissance, dans lequel $Rd_c$, est exprimé comme : $Rd_{cs}$ = $Rd_c$ + HVLoadAh, où HVLoadAh représente un nombre d'ampères-heures requis par la charge haute puissance pendant la charge ;
un ajustement de $Rd_{In}$ à une phase présentant la charge haute puissance activée à $Rd_{Ins}$, où $Rd_{In}$, est exprimé comme : $Rd_{Ins}$ = $Rd_{In}$ + HVLoadAh ; et
un ajustement d'$I_{In}$ à la phase présentant la charge haute puissance activée à $I_{Ins}$, où $I_{In}$, est exprimé comme : $I_{Ins}$ = $I_{In}$ + $I_{load}$, où $I_{load}$ représente un courant de travail pour la charge haute puissance.

**3.** Procédé de calcul du temps restant de la charge d'une batterie selon la revendication 1, dans lequel ladite obtention du mode de charge et ledit ajustement de l'au moins un parmi $Rd_c$, $I_{avg}$, $Rd_{In}$, ou $I_{In}$ sur la base du mode de charge comprennent :

une obtention d'un mode faible puissance à titre de mode de charge, et un ajustement d'$I_{avg}$ à $I_{avg1}$ sur la base du mode faible puissance, dans lequel $I_{avg1}$ est exprimé comme :

$$I_{avg1} = min(I_{avg}, I_{max}) ;$$

et
un ajustement d'$I_{In}$ à $I_{In1}$, dans lequel $I_{In1}$ est exprimé comme : $I_{In1}$ = $min(I_{In}, I_{max})$,
dans lequel $I_{max}$ représente un courant de sortie maximum d'une pile de charge, $min(I_{avg}, I_{max})$ représente un plus petit parmi $I_{avg}$ et $I_{max}$, $min(I_{In}, I_{max})$ représente un plus petit parmi $I_{In}$ et $I_{max}$, et le mode faible puissance est un mode dans lequel $I_{avg}$ ou $I_{In}$ est supérieur à $I_{max}$ dans l'au moins une phase.

**4.** Procédé de calcul du temps restant de la charge d'une batterie selon la revendication 1, dans lequel ladite obtention du mode de charge et ledit ajustement de l'au moins un parmi $Rd_c$, $I_{avg}$, $Rd_{In}$, ou $I_{In}$ sur la base du mode de charge comprennent :

une obtention d'un mode de défaillance à titre de mode de charge, et un ajustement d'$I_{avg}$ à $I_{avg3}$ sur la base du mode de défaillance, dans lequel $I_{avg3}$ est exprimé comme :

$$I_{avg3} = \min(I_{avg}, I_{max}) \; ;$$

et

un ajustement d'$I_{In}$ à $I_{In3}$, dans lequel $I_{In3}$ est exprimé comme $I_{In3} = \min(I_{In}, I_{max})^*AddCf$,
dans lequel $I_{max}$ représente un courant de sortie maximum d'une pile de charge, AddCf représente un coefficient d'ajustement de défaillance, $\min(I_{avg}, I_{max})$ représente un plus petit parmi $I_{avg}$ et $I_{max}$, et $\min(I_{In}, I_{max})$ représente un plus petit parmi $I_{In}$ et $I_{max}$,
dans lequel le mode de défaillance est un état dans lequel le courant de charge est limité.

**5.** Procédé de calcul du temps restant de la charge d'une batterie selon la revendication 1, dans lequel ladite obtention du mode de charge, et un ajustement de l'au moins un parmi $Rd_c$, $I_{avg}$, $Rd_{In}$, ou $I_{In}$ sur la base du mode de charge comprennent :
une obtention d'un mode faible puissance avec une charge haute puissance à titre de mode de charge, et une réalisation, sur la base du mode faible puissance avec la charge haute puissance, des ajustements comprenant :

un ajustement de $Rd_c$ à $Rd_{c4}$, dans lequel $Rd_{c4}$ est exprimé comme : $Rd_{c4} = Rd_c + HVLoadAh$, où HVLoadAh représente un nombre d'ampères-heures requis par la charge haute puissance pendant la charge ;
un ajustement de $Rd_{In}$ à une phase présentant la charge haute puissance activée à $Rd_{In4}$, dans lequel $Rd_{In4}$ est exprimé comme : $Rd_{In4} = Rd_{In} + HVLoadAh$ ;
un ajustement d'$I_{avg}$ à $I_{avg4}$, dans lequel $I_{avg4}$ est exprimé comme :

$$I_{avg4} = \min((I_{avg} + I_{load1}), I_{max}) \; ;$$

et

un ajustement d'$I_{In}$ à une phase présentant la charge haute puissance activée à $I_{In4}$, dans lequel $I_{In4}$ est exprimé comme : $I_{In4} = \min((I_{In} + I_{load1}), I_{max})$,
dans lequel $I_{max}$ représente un courant de sortie maximum d'une pile de charge, et $I_{load1}$ représente un courant de service pour la charge haute puissance, $\min((I_{avg} + I_{load1}), I_{max})$ représente un plus petit parmi $(I_{avg} + I_{load1})$ et $I_{max}$, et $\min((I_{In} + I_{load1}), I_{max})$ représente un plus petit parmi $(I_{In} + I_{load1})$ et $I_{max}$ ; et
dans lequel dans le mode faible puissance avec la charge haute puissance, la charge haute puissance est activée et dans au moins une phase de la charge, $(I_{avg} + I_{load1})$ ou $(I_{In} + I_{load1})$ est supérieur à $I_{max}$.

**6.** Procédé de calcul du temps restant de la charge d'une batterie selon la revendication 1, dans lequel ladite obtention du mode de charge et ledit ajustement de l'au moins un parmi $Rd_c$, $I_{avg}$, $Rd_{In}$, ou $I_{In}$ sur la base du mode de charge comprennent :

une détermination de manière séquentielle (101 ; 102 ; 103) du fait qu'un mode de charge actuel est un mode de défaillance, le mode de changement dynamique, ou un mode faible puissance ;
s'il est déterminé que le mode de charge actuel est un parmi le mode de défaillance, le mode de changement dynamique, et le mode faible puissance, un enregistrement (101a ; 102a ; 103a) d'un premier mode de charge à titre de mode de charge déterminé ;
s'il est déterminé que le mode de charge actuel n'est pas un parmi le mode de défaillance, le mode de changement dynamique, et le mode faible puissance, un enregistrement (104) du premier mode de charge à titre de mode normal ;
une détermination (105) du fait que le mode de charge actuel est un mode avec une charge haute puissance ;
s'il est déterminé que le mode de charge actuel est le mode avec la charge haute puissance, un enregistrement (105a) d'un second mode de charge à titre de mode avec la charge haute puissance ;
s'il est déterminé que le mode de charge actuel n'est pas le mode avec la charge haute puissance, un enregistrement (106) du second mode de charge comme un mode de charge sans haute puissance ;

une détermination du premier mode de charge enregistré et du second mode de charge enregistré à titre du mode de charge ; et

un ajustement de l'au moins un parmi $Rd_c$, $I_{avg}$, $Rd_{In}$, ou $I_{In}$ sur la base du mode de charge, dans lequel le mode de défaillance est un état dans lequel le courant de charge est limité ; dans lequel dans le mode faible puissance, la puissance de sortie de la pile de charge ne correspond pas au courant de charge demandé par le BMS ; et dans lequel un calcul du temps restant de la charge comprend :

un calcul du temps restant de la charge sur la base du premier mode de charge et du second mode de charge, dans lequel le temps restant de la charge est calculé sur la base du courant de charge ajusté selon le mode normal lorsque le premier mode de charge comprend un quelconque parmi le mode de défaillance, le mode de changement dynamique, et le mode de faible puissance, et le temps restant de la charge est calculé sur la base d'un nombre d'ampères-heures de charge et du courant de charge qui sont ajustés selon le mode normal lorsque le second mode de charge comprend le mode avec la charge haute puissance.

7. Appareil de calcul d'un temps restant de charge d'une batterie, la charge comprenant au moins une phase de charge, l'appareil comprenant :

un module d'obtention de mode de charge (201) configuré pour obtenir un mode de charge ; un module d'ajustement de paramètres (202) configuré pour ajuster au moins un parmi $Rd_c$, $I_{avg}$, $Rd_{In}$, ou $I_{In}$ sur la base du mode de charge obtenu, où $Rd_c$ représente un nombre d'ampères-heures de charge requis pour charger la batterie dans une phase de charge actuelle, $I_{avg}$ représente un courant moyen demandé pour charger la batterie dans la phase de charge actuelle, $Rd_{In}$ représente un nombre d'ampères-heures de charge requis pour charger la batterie dans une nième phase de charge subséquente, et $I_{In}$ représente un courant demandé demandé pour charger la batterie dans la nième phase de charge subséquente ; et

un module de calcul de temps restant de charge (203) configuré pour calculer le temps restant de la charge au moyen de $T = \frac{Rd_c}{I_{avg}} + \sum \frac{Rd_{In}}{I_{In}}$, où T représente le temps restant de la charge, $\frac{Rd_c}{I_{avg}}$ représente un temps de charge de la phase de charge actuelle, $\frac{Rd_{In}}{I_{In}}$ représente un temps de charge de la nième phase de charge subséquente, et $\sum \frac{Rd_{In}}{I_{In}}$ représente un temps de charge de l'ensemble des phases de charge subséquentes, dans lequel le module d'obtention de mode de charge (201) est en outre configuré pour obtenir un mode de changement dynamique à titre de mode de charge ; et

dans lequel le module d'ajustement de paramètres (202) est en outre configuré pour ajuster $I_{In}$ à $I_{In2}$ sur la base du mode de changement dynamique, dans lequel :

$I_{In2}$ est obtenu au moyen de : $I_{In2} = min(I_{In}, I_{avgpret})$, où $I_{avgpret}$ représente une valeur de courant moyenne d'une pile de charge, et $min(I_{In}, I_{avgpret})$ représente un plus petit parmi $I_{In}$ et $I_{avgpret}$ ;

$I_{avgpret}$ est obtenu : au moyen d'une obtention de la valeur de courant moyenne de la pile de chargement dans une période de T1 à titre d'$I_{avgpret}$ en réponse à une durée $I_p - M_1 > I_1$ dépassant T1 pendant la charge, où $I_p$ représente un courant de charge demandé par un système de gestion de batterie, BMS, $M_1$ représente un courant de la pile de charge, $I_1$ représente un premier seuil de courant prédéterminé, et T1 représente un premier seuil de temps prédéterminé ; et

dans lequel le mode de changement dynamique est un état dans lequel la durée de $I_p - M_1 > I_1$ dépasse T1 pendant la charge.

8. Support de stockage lisible par ordinateur présentant un programme informatique stocké dessus, le programme informatique amenant un appareil selon la revendication 7 à réaliser le procédé de calcul du temps restant de la charge selon l'une quelconque des revendications 1 à 6.

FIG. 1

| 201 | 202 | 203 |
|---|---|---|
| Charging mode obtaining module | Parameter adjustment module | Charging remaining time calculation module |

Apparatus for calculating remaining time of charging

FIG. 2

**EP 3 915 827 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110562097 A
- KR 20190023801

- US 6928372 B2